# EUROPEAN PATENT APPLICATION

(11) **EP 4 447 100 A1**
(43) Date of publication of application: **16.10.2024**
(21) Application number: 24165810.3
(22) Date of filing: 25.03.2024
(51) Int. Cl.: H01L 21/768, H01L 21/8234, H01L 21/8238, H01L 23/48, H01L 23/522, H01L 23/528, H01L 27/088, H01L 27/118, H01L 29/06, H01L 29/423, H01L 29/66, H01L 29/775, H01L 29/786, H01L 23/535, H01L 27/092

(54) **SEMICONDUCTOR DEVICES**

(30) Priority: 13.04.2023 KR 20230048555
(71) Applicant: Samsung Electronics Co., Ltd., Suwon-si, Gyeonggi-do 16677 (KR)
(72) Inventor: SHIN, Hongsik, 16677 Suwon-si (KR); KOH, Kyongbeom, 16677 Suwon-si (KR); KO, Eunkyung, 16677 Suwon-si (KR); RA, Hyonwook, 16677 Suwon-si (KR); SEO, Dongsoo, 16677 Suwon-si (KR); SEO, Jeongyeon, 16677 Suwon-si (KR); YANG, Kwangyong, 16677 Suwon-si (KR)
(74) Representative: Marks & Clerk LLP

(57) **Abstract**

A semiconductor device may include an active region extending in a first direction; a gate structure extending in a second direction on the active region; a source/drain region on the active region and disposed at least one side of the gate structure; a contact structure on the source/drain region; a device isolation layer surrounding the active region; an interlayer insulating layer on the device isolation layer, the gate structure, and the source/drain region; a vertical power structure penetrating through the device isolation and interlayer insulating layers and connected to the contact structure; a rear power structure electrically connected to the vertical power structure and surrounding an entirety of a lower surface and a portion of a side surface of the vertical power structure; a vertical insulating film between the vertical power structure and the rear power structure; and a rear insulating film covering a side of the rear power structure.

## Description

### BACKGROUND

Example embodiments relate to a semiconductor device.

As demand for high performance, high speed, and/or multifunctionality of a semiconductor device have increased, integration density of a semiconductor device has increased. In response to the trend for high integration of a semiconductor device, a semiconductor device having a back side power delivery network (BSPDN) structure, in which power rails are disposed on a rear surface of a wafer, has been developed. As power is transferred from a rear surface, there have been attempts to develop a semiconductor device having better power transfer from the rear surface.

### SUMMARY

Example embodiments provide a semiconductor device having improved electrical properties.

According to an example embodiment, a semiconductor device may include a substrate including an active region extending in a first direction; a gate structure on the active region, the gate structure extending in a second direction, the second direction intersecting the first direction, and the gate structure intersecting the active region; a source/drain region on the active region, the source/drain region on at least one side of the gate structure; a contact structure on the source/drain region and connected to the source/drain region; a device isolation layer surrounding the active region on the substrate; an interlayer insulating layer on the device isolation layer, the interlayer insulating layer covering the gate structure and the source/drain region; a vertical power structure penetrating through the device isolation layer and the interlayer insulating layer, the vertical power structure being connected to the contact structure and being below the contact structure; a rear power structure surrounding an entirety of a lower surface of the vertical power structure and a portion of a side surface of the vertical power structure, the rear power structure being electrically connected to the vertical power structure; a vertical insulating film covering the side surface of the vertical power structure, the vertical insulating film being between the vertical power structure and the rear power structure; and a rear insulating film covering a side surface of the rear power structure.

According to an example embodiment, a semiconductor device may include a substrate including an active region extending in a first direction; a gate structure on the active region, the gate structure extending in a second direction, the second direction intersecting the first direction, and the gate structure intersecting the active region; a source/drain region on the active region, the source/drain region on at least one side of the gate structure; a contact structure on the source/drain region and connected to the source/drain region; a device isolation layer surrounding the active region on the substrate; an interlayer insulating layer on the device isolation layer, the interlayer insulating layer covering the gate structure and the source/drain region; a vertical power structure penetrating through the substrate, the vertical power structure extending in a third direction, the third direction being perpendicular to an upper surface of the substrate, and the vertical power structure being connected to the contact structure; a first conductive barrier on a side surface of the vertical power structure; a rear power structure electrically connected to the vertical power structure, the rear power structure penetrating through a portion of the substrate and a portion of the device isolation layer; and a rear insulating film covering a side surface of the rear power structure. The rear power structure may overlap the vertical power structure in the second direction and the third direction. A level of an upper end of the rear power structure may be higher than a level of a lower end of the vertical power structure. A width of an upper end of the rear power structure may be greater than a width of the lower end of the vertical power structure.

According to an example embodiment, a semiconductor device may include a substrate including an active region extending in a first direction; a gate structure on the active region, the gate structure extending in a second direction, the second direction intersecting the first direction; a source/drain region on the active region, the source/drain region on at least one side of the gate structure; a contact structure on the source/drain region and connected to the source/drain region; a device isolation layer surrounding the active region on the substrate; an interlayer insulating layer on the device isolation layer, the interlayer insulating layer covering the gate structure and the source/drain region; a vertical power structure penetrating through the device isolation layer and the interlayer insulating layer, the vertical power structure being connected to the contact structure and being below the contact structure; a rear power structure surrounding an entirety of a lower surface of the vertical power structure and a portion of a side surface of the vertical power structure, the rear power structure being electrically connected to the vertical power structure; a first conductive barrier on a side surface of the vertical power structure and the lower surface of the vertical power structure; a vertical insulating film surrounding a side surface of the first conductive barrier; a second conductive barrier on a side surface of the rear power structure and an upper surface of the rear power structure; and a rear insulating film on a side surface of the second conductive barrier. The vertical power structure may extend into a recessed portion of the substrate. An upper end of the vertical power structure may include a recess. A portion of the contact structure may extend into the recess of the upper end of the vertical power structure.

At least some of the above and other features of the invention are set out in the claims.

### BRIEF DESCRIPTION OF DRAWINGS

The above and other aspects, features, and advantages in example embodiments will be more clearly understood from the following detailed description, taken in combination with the accompanying drawings, in which:
FIG. 1 is a plan diagram illustrating a semiconductor device according to an example embodiment;
FIG. 2 is a cross-sectional diagram illustrating a semiconductor device according to an example embodiment;
FIGS. 3A and 3B are enlarged diagrams illustrating regions A1 and A2 in FIG. 2, respectively;
FIG. 4 is a cross-sectional diagram illustrating a semiconductor device according to an example embodiment;
FIG. 5 is a cross-sectional diagram illustrating a semiconductor device according to an example embodiment;
FIGS. 6A to 6E are enlarged diagrams illustrating region A1 according to example embodiments;
FIGS. 7A to 7D are enlarged diagrams illustrating region A1 according to example embodiments;
FIG. 8 is a cross-sectional diagram illustrating a semiconductor device according to an example embodiment;
FIG. 9 is a cross-sectional diagram illustrating a semiconductor device according to an example embodiment;
FIGS. 10A and 10B are cross-sectional diagram illustrating a semiconductor device according to an example embodiment;
FIG. 11 is a cross-sectional diagram illustrating a semiconductor device according to an example embodiment; and
FIGS. 12 to 18 are cross-sectional diagrams illustrating processes of a method of manufacturing a semiconductor device according to an example embodiment.

### DETAILED DESCRIPTION

Hereinafter, example embodiments will be described as follows with reference to the accompanying drawings. Hereinafter, it can be understood that terms such as 'on,' `upper portion,' `upper surface,' 'below,' `lower portion,' `lower surface,' `side surface,' and the like may be indicated by reference numerals and may be based on drawings, unless otherwise indicated. Relative terms such as "upper", "lower", "higher", "above", "below", etc. may be relative to a particular vertical direction. For instance, a vertical direction may be a direction perpendicular to the substrate (e.g. perpendicular to an upper surface of the substrate). It will be appreciated that these terms may be considered relative to a structure of the semiconductor device. Accordingly, these terms need not imply any particular orientation of the semiconductor device in use.

The term "overlap" (or "overlapping", or like terms), as may be used herein, is intended to broadly refer to a first element that intersects with at least a portion of a second element in the certain direction (e.g., in a vertical direction, perpendicular to the upper surface of the substrate), but does not require that the first and second elements be completely aligned with one another. That is, components or layers described to "overlap" in a particular direction may be at least partially obstructed by one another when viewed along a line extending in the particular direction.

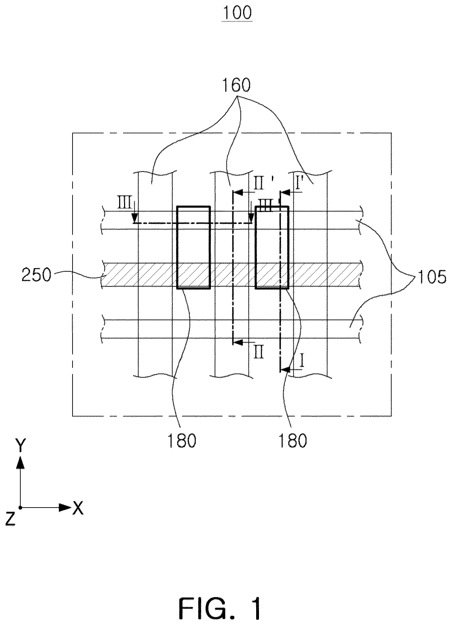

FIG. 1 is a plan diagram illustrating a semiconductor device according to an example embodiment.

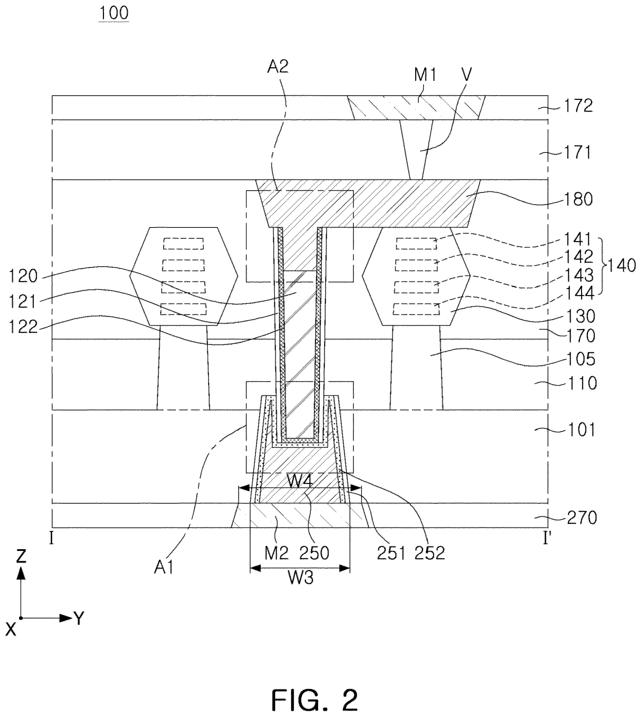

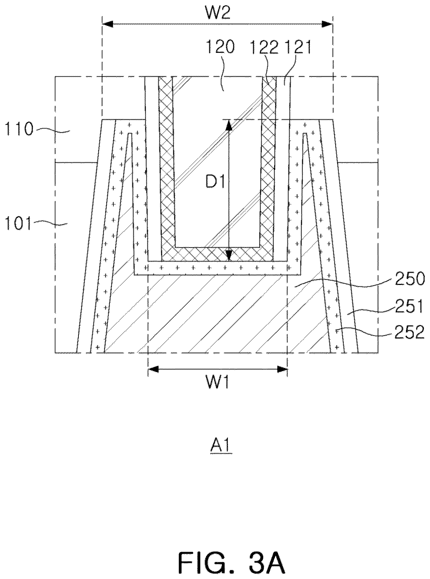

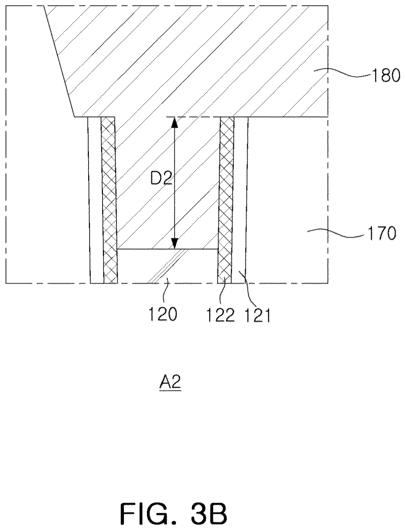

FIGS. 2, 4, and 5 are cross-sectional diagrams illustrating a semiconductor device according to example embodiments. FIGS. 2, 4, and 5 are cross-sectional diagrams illustrating the semiconductor device in FIG. 1 taken along lines I - I ', II - II', and III - III'. For ease of description, only a portion of components of a semiconductor device are illustrated in FIG. 1. FIGS. 3A and 3B are enlarged diagrams illustrating regions A1 and A2 in FIG. 2, respectively.

Referring to FIGS. 1 to 5, a semiconductor device 100 may include a substrate 101 including active regions 105, channel structures 140 including first to fourth channel layers 141, 142, 143, and 144 spaced apart from each other vertically on the active regions 105, gate structures 160 extending by intersecting the active regions 105 and each including a gate electrode 165, source/drain regions 130 in contact with the channel structures 140, a vertical power structure 120 electrically connected to the source/drain region 130, and a rear power structure 250 electrically connected to the vertical power structure 120. The semiconductor device 100 may further include contact structures 180 connected to the source/drain region 130, upper vias V on the contact structures 180 and upper interconnection lines M1 on the upper vias V. The semiconductor device 100 may further include a device isolation layer 110, internal spacer layers 150, interlayer insulating layer 170, first and second upper insulating layers 171, 172, and rear insulating layer 270. Each of the gate structures 160 may include gate dielectric layers 162, gate spacer layers 164, and gate electrode 165.

The substrate 101 may have an upper surface extending in an X-direction and a Y-direction. The substrate 101 may include a semiconductor material, such as a group IV semiconductor, a group III-V compound semiconductor, or a group II-VI compound semiconductor. For example, the group IV semiconductor may include silicon, germanium, or silicon-germanium. The substrate 101 may be provided as a bulk wafer, an epitaxial layer, a silicon on insulator (SOI) layer, or a semiconductor on insulator (SeOI) layer.

The substrate 101 may include active regions 105 disposed thereon. However, in some example embodiments, the active regions 105 may be a component separate from the substrate 101. In some example embodiments, the substrate 101 below the active regions 105 may be removed.

The active regions 105 may extend in a first direction, for example, the X-direction. The active regions 105 may be defined at a desired and/or alternatively predetermined depth from an upper surface in a portion of the substrate 101. The active regions 105 may be formed by a portion of the substrate 101 or may include an epitaxial layer grown from the substrate 101. Each of the active regions 105 may include active fins protruding upwardly. The active regions 105 may form, together with the channel structures 140, an active structure in which a channel region of a transistor is formed. Each of the active regions 105 may include an impurity region. The impurity region may form at least a portion of a well region of a transistor.

A device isolation layer 110 may be disposed between active regions 105 adjacent to each other in the Y-direction. Upper surfaces of the active regions 105 may be disposed on a level higher than a level of the upper surface of the device isolation layer 110. The active regions 105 may be partially recessed on at least one side of the gate structures 160, and source/drain regions 130 may be disposed on the recess regions.

The device isolation layer 110 may fill a region between the active regions 105 and may define the active regions 105 in the substrate 101. The device isolation layer 110 may be formed by, for example, a shallow trench isolation (STI) process. The device isolation layer 110 may expose an upper surface of the active region 105, or may partially expose an upper portion. The device isolation layer 110 may be formed of an insulating material. The device isolation layer 110 may include, for example, oxide, nitride, or a combination thereof.

The rear insulating layer 270 may be disposed to cover a lower surface of the substrate 101. In the substrate 101, when an upper surface on which active regions 105 are disposed is referred to as a first surface, a rear insulating layer 270 may be disposed on a second surface of the substrate 101 opposite to the first surface.

A level of a lower surface of the substrate 101 may be the same as or substantially the same as a level of a lower surface of the rear power structure 250. A thickness of the rear insulating layer 270 may be varied in example embodiments. The rear insulating layer 270 may include an insulating material such as oxide, nitride, or a combination thereof. In some example embodiments, the rear insulating layer 270 may include, for example, a native oxide of the substrate 101.

The gate structures 160 may be disposed to intersect the active regions 105 on the active regions 105 and may extend in a second direction, for example, the Y-direction. A channel region of transistors may be formed in the active regions 105 and the channel structure 140 intersecting the gate electrode 165 of the gate structures 160. A portion of the gate structures 160 may be disposed on a linear line in the Y-direction and may be spaced apart from each other.

Each of the gate structures 160 may include gate dielectric layers 162, gate spacer layers 164, and gate electrode 165. In example embodiments, each of the gate structures 160 may further include a capping layer on the upper surface of the gate electrode 165. Alternatively, a portion of the first upper insulating layer 171 on the gate structures 160 may be referred to as a gate capping layer.

The gate dielectric layers 162 may be disposed between the active region 105 and the gate electrode 165 and between the channel structure 140 and the gate electrode 165, and may be disposed to cover at least a portion of the surfaces of the gate electrode 165. For example, the gate dielectric layers 162 may be disposed to surround the entirety of surfaces other than an uppermost surface of the gate electrode 165. The gate dielectric layers 162 may extend to a region between the gate electrode 165 and the gate spacer layers 164, but example examples embodiment are not limited thereto. The gate dielectric layer 162 may include an oxide, a nitride, or a high-x material. The high-κ material may refer to a dielectric material having a dielectric constant higher than that of silicon oxide (SiO₂). The high-x material may be at least one of, for example, aluminum oxide (Al₂O₃), tantalum oxide (Ta₂O₃), titanium oxide (TiOz), yttrium oxide (Y₂O₃), zirconium oxide (ZrO₂), zirconium silicon oxide (ZrSiₓO_{y}), hafnium oxide (HfO₂), hafnium silicon oxide (HfSiₓO_{y}), lanthanum oxide (La₂O₃), lanthanum aluminum oxide (LaAlₓO_{y}), lanthanum hafnium oxide (LaHfₓO_{y}), hafnium aluminum oxide (HfAlₓO_{y}), and praseodymium oxide (Pr₂O₃). In example embodiments, the gate dielectric layer 162 may have a multilayer structure.

The gate electrode 165 may include a conductive material, for example, a metal nitride such as titanium nitride (TiN), tantalum nitride (TaN), or tungsten nitride (WN), and/or a metal material such as aluminum (Al), tungsten (W), or molybdenum (Mo) or semiconductor materials such as doped polysilicon, and/or a combination thereof. In example embodiments, the gate electrode 165 may have a multilayer structure.

The gate spacer layers 164 may be disposed on both side surfaces of the gate electrode 165 on the channel structure 140. The gate spacer layers 164 may insulate the source/drain region 130 and the gate electrodes 165. In example embodiments, a shape of an upper end of the gate spacer layers 164 may be varied, and the gate spacer layers 164 may have a multilayer structure. The gate spacer layers 164 may include at least one of oxide, nitride, and oxynitride, and may include, for example, a low dielectric constant layer.

The channel structures 140 may be disposed on the active regions 105 in regions in which the active regions 105 may intersect the gate structures 160. Each of the channel structures 140 may include first to fourth channel layers 141, 142, 143, and 144, which may be two or more channel layers spaced apart from each other in the Z-direction. That is, a plurality of channel layers 141, 142, 143, and 144 spaced apart from each other in a third direction (Z-direction) perpendicular to the first direction (X-direction) and the second direction (Y-direction) on the active region 105 and surrounded by the gate structure 160 may be further included. The channel structures 140 may be associated with the source/drain regions 130. The channel structures 140 may have a width the same as or smaller than a width of the active region 105 in the Y-direction, and may have a width the same as or similar to a width of the gate structures 160 in the X-direction. In a cross-section taken in the Y-direction, a lower channel layer among the first to fourth channel layers 141, 142, 143, and 144 may have a width equal to or larger than that of an upper channel layer. In some example embodiments, the channel structures 140 may have a reduced width as compared to that of the gate structures 160, such that side surfaces may be disposed below the gate structures 160 in the X-direction.

The channel structures 140 may be formed of a semiconductor material, and may include, for example, at least one of silicon (Si), silicon germanium (SiGe), and germanium (Ge). The channel structures 140 may be formed of the same material as that of the active regions 105, for example. The number and the shape of channel layers included in a channel structure 140 may be varied in example embodiments.

In the semiconductor device 100, a gate electrode 165 may be disposed between the active region 105 and the channel structures 140, between the first to fourth channel layers 141, 142, 143, and 144 of the channel structures 140, and on the channel structures 140. Accordingly, the semiconductor device 100 may include a transistor having a multi-bridge channel field effect transistor (MBCFET^{™}) structure, which may be a gate-all-around type field effect transistor. However, in some example embodiments, the semiconductor device 100 may not include the channel structures 140, and may have, for example, a fin field effect transistor (FinFET) structure.

The source/drain region 130 may be in contact with the channel structures 140 on both sides of the gate structures 160, respectively. The source/drain region 130 may be disposed in regions in which an upper portion of the active region 105 is partially recessed. As illustrated in FIG. 2, the source/drain region 130 may be electrically connected to the rear power structure 250 through the contact structure 180, an upper via V, an upper interconnection line M1, and a vertical power structure 120, and may receive power.

Upper surfaces of the source/drain region 130 may be disposed on a level the same as or similar to a level of lower surfaces of the gate structures 160 on the channel structures 140, but a level of the upper surfaces of the source/drain region 130 may be varied in example embodiments. The source/drain region 130 may have a polygonal shape or an elliptical shape as illustrated in FIG. 2 in a cross-section taken in the Y-direction, but the shape is not limited to the illustrated example. The source/drain region 130 may include a semiconductor material, for example, silicon (Si) and/or germanium (Ge), and may further include impurities.

The internal spacer layers 150 may be disposed parallel to the gate electrode 165 between the first to fourth channel layers 141, 142, 143, and 144 in the Z-direction. The gate electrode 165 may be stably spaced apart from the source/drain regions 130 by the internal spacer layers 150 and may be electrically isolated therefrom. A side surface of the internal spacer layers 150 opposing the gate electrode 165 may have a rounded shape, rounded inwardly toward the gate electrode 165, but example examples embodiment are not limited thereto. The internal spacer layers 150 may include at least one of oxide, nitride, and oxynitride, and may include, for example, a low dielectric constant layer. However, in some example embodiments, the internal spacer layers 150 may not be provided.

The contact structures 180 may be disposed on the source/drain region 130. The contact structures 180 may penetrate through the interlayer insulating layer 170 and may be connected to the source/drain regions 130. The contact structures 180 may have an inclined side surface, such that a width thereof may decrease toward the substrate 101 due to an aspect ratio, but example embodiments are not limited thereto. The contact structures 180 may be disposed to be in contact with a portion of surfaces including an upper surface of the source/drain region 130 by being partially recessed into the source/drain region 130. Accordingly, a portion of the contact structure 180 may overlap a portion of the source/drain region 130 in the first direction (X-direction). In a region not illustrated, other gate contact structures 180 may be further disposed on the gate electrodes 165.

Each of the contact structures 180 may include a metal silicide layer on a lower end, and may further include a barrier layer on the metal silicide layer and sidewalls. The barrier layer may include, for example, a metal nitride such as titanium nitride (TiN), tantalum nitride (TaN), or tungsten nitride (WN). The contact structures 180 may include, for example, a metal material such as aluminum (Al), tungsten (W), or molybdenum (Mo). In example embodiments, the number and arrangement of the conductive layers included in the contact structures 180 may be varied.

Among the contact structures 180, the contact structure 180 connected to the source/drain region 130 may be relatively long (e.g. may extend) in the Y-direction, and may also be connected to the vertical power structure 120. The contact structure 180 may be connected to an upper surface of the vertical power structure 120, but example examples embodiment are not limited thereto. In some example embodiments, the contact structure 180 may be connected to a side surface of the vertical power structure 120 or to an upper surface and a side surface of the vertical power structure 120. In some example embodiments, the contact structure 180 and the vertical power structure 120 may be integrated with each other. An upper surface or upper end of the vertical power structure 120 may be disposed at the same level as a level of an upper surface or upper end of the source/drain region 130. A lower surface of the vertical power structure 120 may be disposed on a level lower than a level of an upper surface of the substrate 101.

As illustrated in FIG. 2, the contact structure 180 may be disposed in a recess in a portion of an upper end of the vertical power structure 120. The contact structure 180 may be in contact with an internal side surface of the first conductive barrier 122 and may extend into the first conductive barrier 122. The contact structure 180 may be disposed in the vertical insulating film 121. That is, a portion of the contact structure 180 may extend into a recess that is surrounded by the vertical insulating film 121. A level difference D2 between the upper end of the vertical power structure 120, before recessing and the vertical power structure 120 after recessing, illustrated in FIG. 3B may vary. As the upper end of the vertical power structure 120 is recessed, resistance may be limited and/or addressed. The level difference D2 may correspond to a length in the Z-direction of a portion of the contact structure 180 extending into the recessed portion of the vertical power structure 120.

The vertical power structure 120 may be disposed to connect the contact structure 180 to the rear power structure 250. As illustrated in FIG. 2, the vertical power structure 120 may be disposed between source/drain regions 130 adjacent to each other in the Y-direction. The vertical power structure 120 may be disposed to penetrate through the interlayer insulating layer 170, the device isolation layer 110, and the substrate 101.

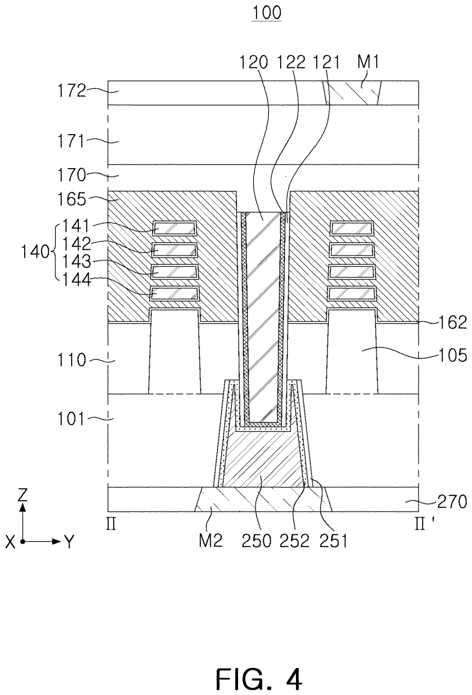

As illustrated in FIGS. 1 to 2, the vertical power structure 120 may be disposed in a region in which gate structures 160 are spaced apart from each other in the Y-direction and/or overlapping the region in the X-direction. The vertical power structure 120 may be spaced apart from the gate structures 160 in the Y-direction. Accordingly, the vertical power structure 120 may not overlap the gate structures 160 in the X-direction. The vertical power structure 120 may extend in a line shape in the X-direction, but the extended length is not limited to the example illustrated in FIG. 1. In some example embodiments, the vertical power structure 120 may have an elliptical or a circular shape in a plan view. In some example embodiments, the vertical power structure 120 may not extend to a region between gate structures 160 adjacent to each other in the Y-direction. In FIG. 4, an upper end of the vertical power structure 120 may be disposed on a level lower than a level of an uppermost surface of the gate electrode 165, but the relative level relationship between the vertical power structure 120 and the gate structure 160 is not limited thereto.

In example embodiments, the vertical power structure 120 may be connected to the contact structure 180 through an upper surface and may be connected to the rear power structure 250 through a lower surface. An upper surface or an upper end of the vertical power structure 120 may be disposed on a level lower than a level of an upper surface or an upper end of the source/drain region 130. A lower end of the vertical power structure 120 may be disposed on a level lower than a level of a lower surface of the source/drain region 130, may be disposed on a level lower than levels of an upper surface and a lower surface of the active regions 105, may be disposed on a level lower than a level of an interfacial surface between the device isolation layer 110 and the substrate 101, and may be disposed on a level higher than a level of a lower surface of the substrate 101. The vertical power structure 120 may have an inclined side surface, such that a width thereof (e.g. in the Y direction) may decrease toward the substrate 101 due to an aspect ratio, but example examples embodiment are not limited thereto.

The vertical power structure 120 may include a conductive material, for example, a metal material such as tungsten (W), molybdenum (Mo), copper (Cu), and/or cobalt (Co).

The first conductive barrier 122 may be disposed to cover side surfaces of the vertical power structure 120. The first conductive barrier 122 may cover a side surface of the vertical power structure 120 and also a lower surface. The barrier layer may include, for example, a metal nitride such as titanium nitride (TiN), tantalum nitride (TaN), or tungsten nitride (WN).

The vertical insulating film 121 may be disposed to cover side surfaces of the first conductive barrier 122. In some example embodiments, the vertical insulating film 121 may be disposed only in a region between the vertical power structure 120 and the substrate 101, and the first conductive barrier 122 may not be present and the vertical insulating film 121 may be disposed to cover side surfaces of the vertical power structure 120. A lower end of the vertical insulating film 121 may be disposed on a level lower than a level of the interfacial surface between the substrate 101 and the device isolation layer 110, and may electrically isolate the vertical power structure 120 and the substrate 101 from each other. The vertical insulating film 121 may include a plurality of layers and may include an insulating material, and may include, for example, at least one of oxide, nitride, and oxynitride.

The rear power structure 250 may be connected to a lower end or a lower surface of the vertical power structure 120. The rear power structure 250 may form a BSPDN configured to apply power or ground voltage, and may also be referred to as a rear power rail or a buried power rail. For example, the rear power structure 250 may be configured as a buried interconnection line extending in one direction, for example, in the X-direction below the vertical power structure 120, but the shape of the rear power structure 250 is not limited thereto. For example, in some example embodiments, the rear power structure 250 may include a via region and a line region.

The rear power structure 250 may be formed to surround the entirety of the lower surface of the vertical power structure 120 and a portion of a side surface connected to the lower surface (e.g. surround a lower end or tip of the vertical power structure 120). In this case, a portion of a side surface of the vertical insulating film 121 on the first conductive barrier 122 may be surrounded by the rear power structure 250. In some example embodiments, the vertical power structure 120 may be formed by being recessed into a portion of the rear power structure 250, and the vertical insulating film 121 or the first conductive barrier 122 may also be recessed. In example embodiments, whether each of the vertical power structure 120, the vertical insulating film 121, and the first conductive barrier 122 is recessed and the degree of being recessed thereof may vary.

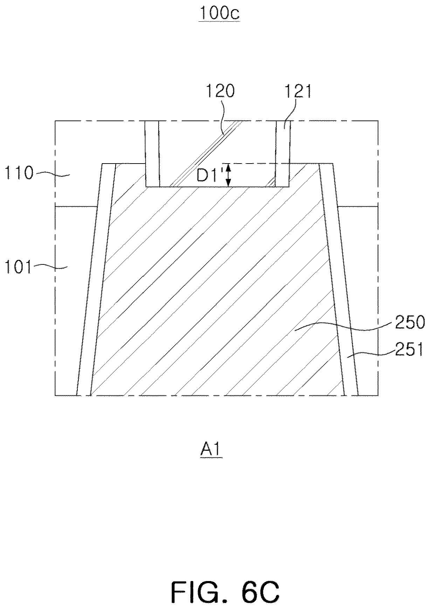

The upper end of the rear power structure 250 may be disposed on a level higher than a level of the interfacial surface between the device isolation layer 110 and the substrate 101, and may be disposed on a level higher than a level of the lower end of the vertical power structure 120. The lower end of the vertical power structure 120 may be disposed on a level higher than a level of the interfacial surface between the substrate 101 and the device isolation layer 110 and lower than the upper end of the rear power structure 250 (as shown in FIG. 6C). Alternatively, the lower end of the vertical power structure 120 may be disposed on a level lower than a level of the interfacial surface between the substrate 101 and the device isolation layer 110 and lower than the upper end of the rear power structure 250 (as shown in FIG. 3A). A level difference D1 between the upper end of the rear power structure 250 and the lower end of the vertical power structure 120 illustrated in FIG. 3A may vary. Also, a width W2 of the upper end of the rear power structure 250 (e.g. in the X direction) may be greater than a width W1 of the lower end of the vertical power structure 120 (e.g. in the X direction). Also, a width W4 of the upper end of the lower interconnection line M2 (e.g. in the X direction) may be greater than a width W3 of the lower end of the rear power structure 250 (e.g. in the X direction). As the rear power structure 250 may surround the entirety of the lower surface and a portion of the side surface of the vertical power structure 120 and may be electrically connected thereto, resistance may be limited and/or addressed and electrical properties may be improved.

A width of the rear power structure 250 may continuously increase toward the bottom, but example examples embodiment are not limited thereto. For example, the width W3 of the lower end of the rear power structure 250 may be greater than the width W2 of the upper end of the rear power structure 250.

The upper end of the rear power structure 250 may be disposed on a level higher than a level of the lower end of the vertical power structure 120, and may be disposed on a level higher than or the same as a level of the lower end of the device isolation layer 110. In some example embodiments, an upper end of the rear power structure 250 may be disposed on a level lower than a level of a lower end of the device isolation layer 110.

The rear power structure 250 may include a conductive material, for example, a metal material such as tungsten (W), molybdenum (Mo), copper (Cu), or cobalt (Co), and the vertical power structure 120 and may include the same material.

The rear power structure 250 may be connected to a lower end or a lower surface of the vertical power structure 120. The lower interconnection line M2 may be disposed on the lower surface of the rear power structure 250 and may be electrically connected thereto. The rear power structure 250 and lower interconnection line M2 may form a BSPDN, and each of the rear power structure 250 and the lower interconnection line M2 may have inclined side surfaces such that a width thereof may decrease toward the upper portion.

The rear insulating film 251 may be disposed to cover side surfaces of the rear power structure 250. The rear insulating film 251 may electrically isolate the rear power structure 250 and the substrate 101 from each other. In some example embodiments, the rear insulating film 251 may include a plurality of layers and may include an insulating material. For example, the rear insulating film 251 may include at least one of oxide, nitride, and oxynitride.

The second conductive barrier 252 may be disposed to surround a side surface of the rear power structure 250 in the rear insulating film 251. The second conductive barrier 252 may cover a side surface of the rear power structure 250 and also an upper surface, and the rear power structure 250 may be electrically connected to the vertical power structure 120 through the first conductive barrier 122 and the second conductive barrier 252. The barrier layer may include, for example, a metal nitride such as titanium nitride (TiN), tantalum nitride (TaN), or tungsten nitride (WN), and the second conductive barrier 252 may include the same material as that of the first conductive barrier 122.

The first upper insulating layer 171 may be disposed to cover upper surfaces of the source/drain region 130 and the gate structures 160 and to cover an upper surface of the device isolation layer 110. The second upper insulating layer 172 may be disposed to cover an upper surface of the first upper insulating layer 171. The rear insulating layer 270 may be disposed to cover a lower surface of the substrate 101 and may surround the rear power structure 250.

The first and second upper insulating layers 171 and 172 and the rear insulating layer 270 may include at least one of oxide, nitride, and oxynitride, and may include, for example, a low dielectric constant material. In example embodiments, each of the first and second upper insulating layers 171 and 172 and the rear insulating layer 270 may include a plurality of insulating layers.

The via V may penetrate through the first upper insulating layer 171. The via V may be connected to the contact structures 180. The via V may be formed of a conductive material.

The upper interconnection line M1 and the via V may form a back end of line (BEOL). The lower interconnection line M2 may be provided as an interconnection portion for power transfer, and the upper interconnection lines M1 and via V may be provided as an interconnection portion for signal transfer. In example embodiments, the signal network may be configured to be connected to the device region (e.g., the source/drain region 130 and the gate electrode 165) through the contact structure 180 from the upper interconnection line M1 and the via V, and the power transfer network may be configured to penetrate through the substrate 101 from the lower interconnection line M2 and to be connected to the device region (e.g., source/drain region 130). In some example embodiments, an insulating layer may be further disposed between the lower interconnection line M2 and the lower surface of the substrate 101.

The semiconductor device 100 may be packaged by inverting the structure in FIGS. 2, 4, and 5, such that the rear power structure 250 may be disposed on an upper portion, but the packaging form of the semiconductor device 100 is not limited thereto. Since the semiconductor device 100 may include the rear power structure 250 disposed below the source/drain region 130, integration density may be improved. Also, since the rear power structure 250 may surround the entirety of the lower surface of the vertical power structure 120 and a portion of the side surface and may be electrically connected thereto, resistance may be limited and/or addressed and electrical properties may be improved.

In the description of example embodiments below, the description of overlapping features already described above will not be repeated.

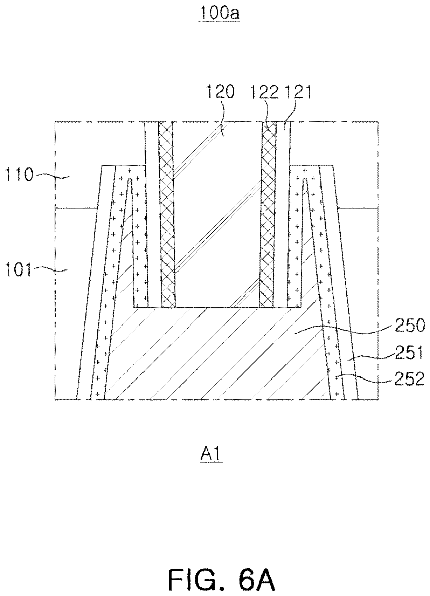

FIGS. 6A to 6E are enlarged diagrams illustrating region A1 according to example embodiments.

Referring to FIG. 6A, in the semiconductor device 100a, the first conductive barrier 122 and/or the second conductive barrier 252 may not be disposed on the lower surface of the vertical power structure 120. In example embodiments, each of the first conductive barrier 122 and the second conductive barrier 252 may include a region extending vertically on both sides and may not include a central region extending horizontally.

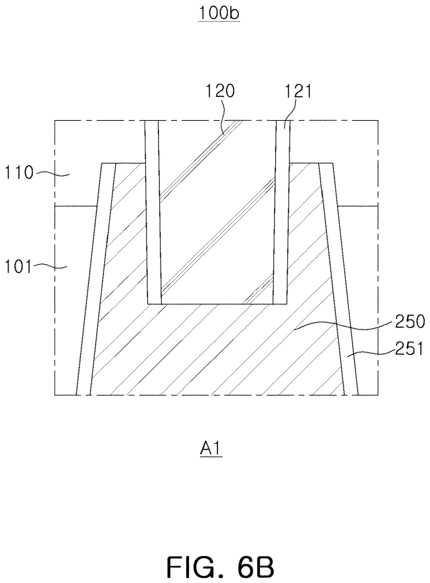

Referring to FIG. 6B, in the semiconductor device 100b, the first conductive barrier 122 and the second conductive barrier 252 in the example embodiment in FIG. 3A may not be present in the semiconductor device 100b. The presence or absence of the first conductive barrier 122 and the second conductive barrier 252 may be variously applied to other example embodiments.

Referring to FIG. 6C, in the semiconductor device 100c, when the rear power structure 250 is formed, the entirety or a portion of each of the vertical power structure 120, the vertical insulating film 121, and the first conductive barrier 122 in the example embodiment in FIG. 3A, which may be disposed on a level lower than a level of the upper end of the rear power structure 250, may be recessed. A lower end of the recessed vertical power structure 120 may be disposed on a level higher than a level of a lower end of the device isolation layer 110. A level difference D1' between the upper end of the rear power structure 250 and the lower end of the vertical power structure 120 may vary.

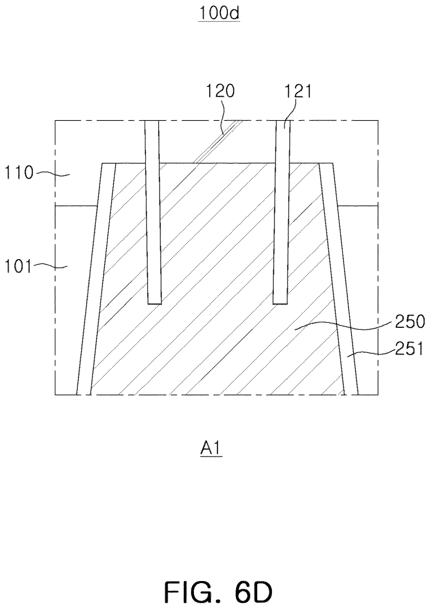

Referring to FIG. 6D, in the semiconductor device 100d, a lower end of the recessed vertical power structure 120 may be at the same level as a level of an upper end of the rear insulating film 251. Whether each of the vertical power structure 120, the vertical insulating film 121, and the first conductive barrier 122 in the example embodiment in FIG. 3A is recessed and the degree of being recessed thereof may vary and may be different from the example embodiments in FIGS. 6C and 6D.

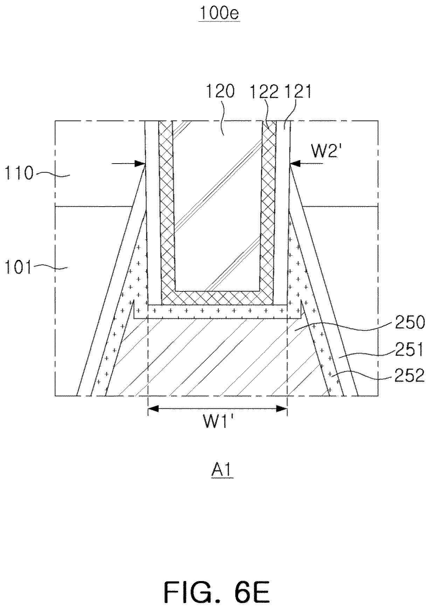

Referring to FIG. 6E, in the semiconductor device 100e, a form in which the rear power structure 250 surrounds the vertical power structure 120 may be a form in which the rear insulating film 251 and the vertical insulating film 121 are in contact with each other. That is, the rear insulating film 251 may be in contact with the side surface of the vertical insulating film 121. A difference between a width W2' of the upper end of the rear insulating film 251 and a width W1' of the lower end of the vertical insulating film 121 may correspond to a difference depending on an inclination of the vertical insulating film 251 or may be the same. A shape in which the second conductive barrier 252 and the rear insulating film 251 surround a portion of the side surface of the vertical power structure 120 may vary depending on the inclination of the vertical insulating film 121 and the rear insulating film 251, other than the example embodiment in FIG. 6E.

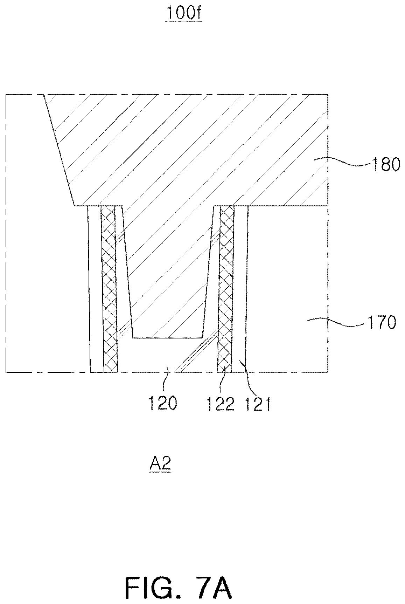

FIGS. 7A to 7D are enlarged diagrams illustrating region A1 according to example embodiments.

Referring to FIG. 7A, in the semiconductor device 100f, when the contact structure 180 is formed, a central portion of the upper surface of the vertical power structure 120 may be disposed on a level lower than a level of the edge of the upper surface. A shape in which a portion of an upper end of the vertical power structure 120 is recessed and the contact structure 180 is formed may be varied in addition to the example embodiment in FIG. 7A, such as an example in which the lower end of the contact structure 180 may have a semicircular shape.

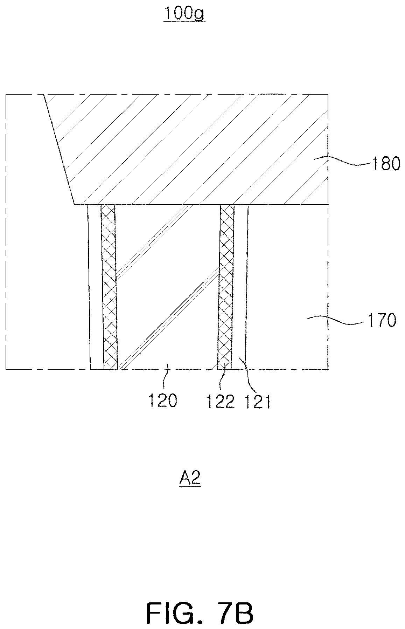

Referring to FIG. 7B, in the semiconductor device 100g, a contact structure 180 may be formed without an upper end of the vertical power structure 120 being recessed. Even in this case, by forming the contact structure 180 such that the interfacial surface between the vertical power structure 120 and the contact structure 180 is clear (e.g. there is direct contact between the vertical power structure 120 and the contact structure 180), resistance may be limited and/or addressed.

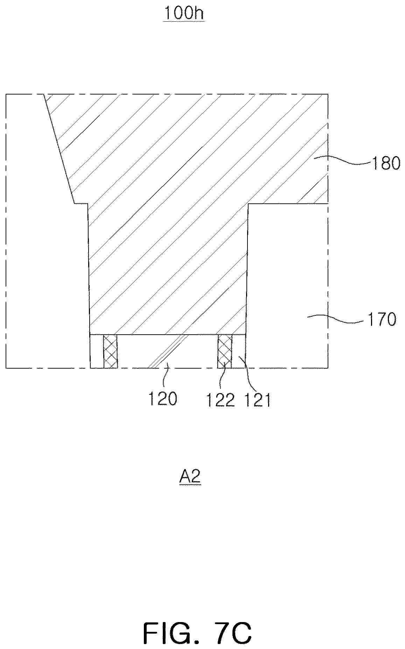

Referring to FIG. 7C, in the semiconductor device 100h, when the contact structure 180 is formed, the vertical insulating film 121 or the first conductive barrier 122 may be recessed together. In this case, a lower surface of the contact structure 180 may be in contact with an upper end of the vertical insulating film 121. In some example embodiments, only the first conductive barrier 122 may be recessed such that the contact structure 180 may extend downwardly along an upper end of the first conductive barrier 122.

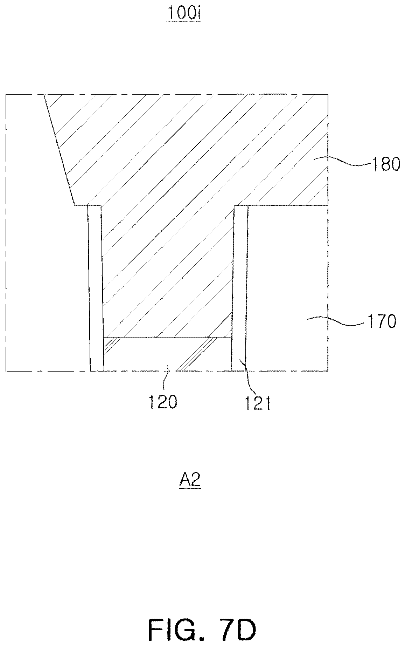

Referring to FIG. 7D, in the semiconductor device 100i, the first conductive barrier 122 may not be present in the vertical insulating film 121. In some example embodiments, only the upper end a portion of the first conductive barrier 122 may be removed and the first conductive barrier 122 may be disposed on a level lower than a level of the vertical insulating film 121.

In addition to the example embodiments in FIGS. 6A to 6E and 7A to 7D, the shapes, arrangement forms, and presence and absence of the vertical power structure 120, the vertical insulating film 121, the first conductive barrier 122, the contact structure 180, the rear power structure 250, the rear insulating film 251 or the second conductive barrier 252 may be varied.

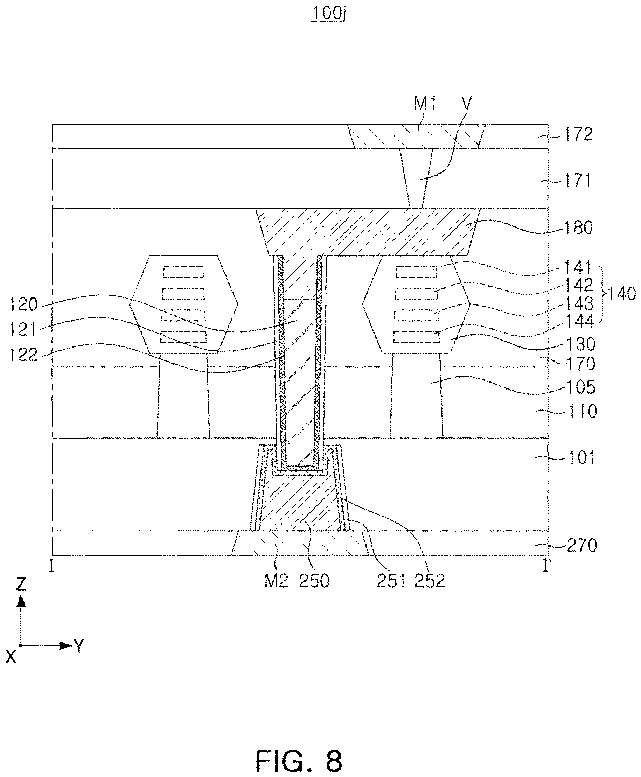

FIGS. 8 to 11 are cross-sectional diagrams illustrating a semiconductor device according to example embodiments.

Referring to FIG. 8. In the semiconductor device 100j, an upper end of the rear power structure 250 may be disposed on a level lower than a level of the interfacial surface between the substrate 101 and the device isolation layer 110. The lower end of the vertical power structure 120 may be formed in various positions on a level lower than a level of the upper end of the rear power structure 250.

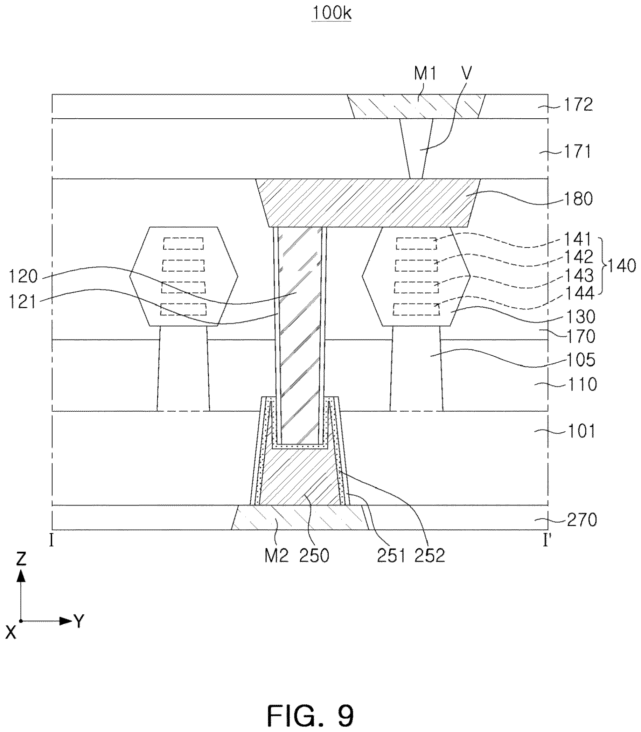

Referring to FIG. 9, in a semiconductor device 100k, a second conductive barrier 252 may be present and a first conductive barrier 122 may not be present. In some example embodiments, the first conductive barrier 122 may be present, but the second conductive barrier 252 may not be present, and both of the first and second conductive barriers 122 and 252 may not be present or may be present.

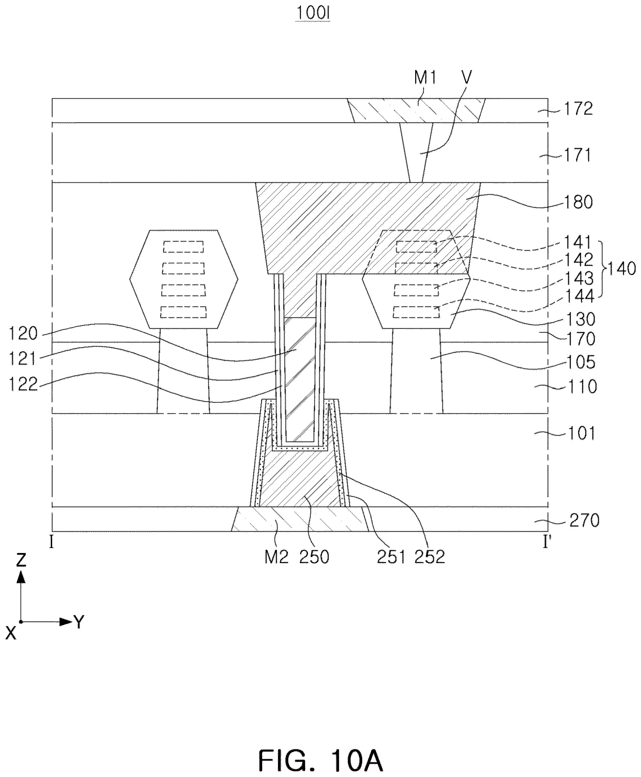

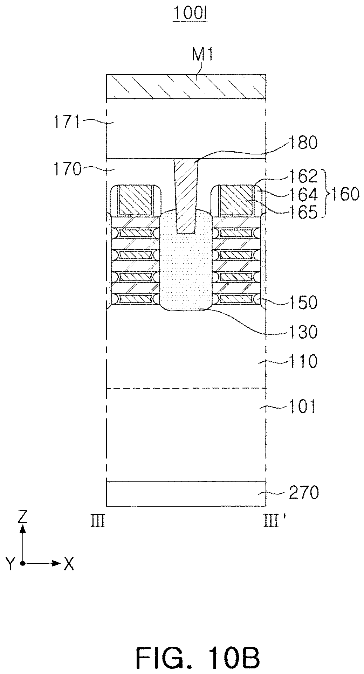

Referring to FIGS. 10A and 10B, in the semiconductor device 100l, the lower end of the contact structure 180 may be recessed into a portion of the source/drain region 130 such that a region in which the contact structure 180 overlaps the source/drain region 130 in the first direction (X-axis direction) may be formed. In this case, the lower end of the contact structure 180 extending downwardly may be disposed on the same level as a level of the lower end of the channel layer 142 disposed on the second highest level in the third direction among the plurality of channel layers 141, 142, 143, and 144. A region in which the contact structure 180 and the source/drain region 130 overlap each other in the first direction (X-axis direction) may be different from the example embodiment in FIG. 10.

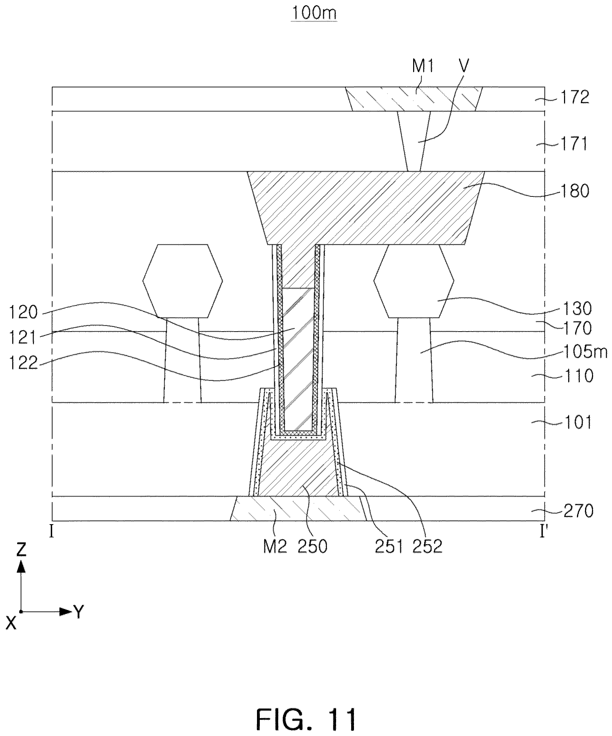

Referring to FIG. 11, a semiconductor device 100m may have a FinFET structure. In the semiconductor device 100m, the source/drain region 130 may be disposed at the upper end of the active region 105m, and the channel structures 140 of the semiconductor device 100 in FIG. 2 may not be included.

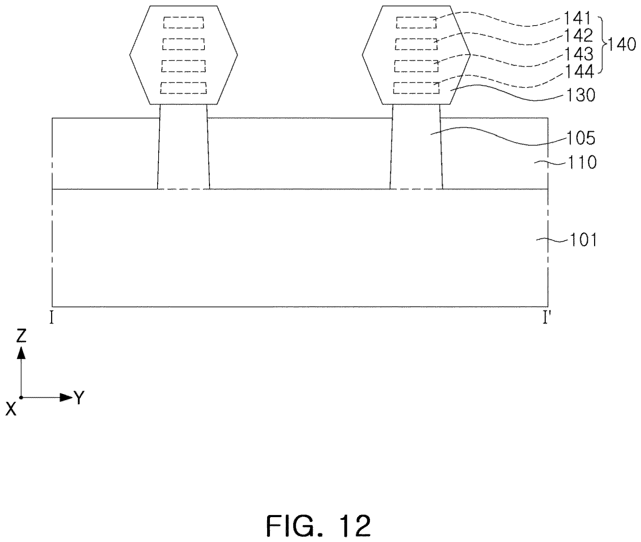

FIGS. 12 to 20 are diagrams illustrating processes of a method of manufacturing a semiconductor device according to an example embodiment. FIGS. 12 to 20 illustrates an example embodiment of a method of manufacturing the semiconductor device in FIGS. 1 to 5, illustrating a cross-section corresponding to FIG. 2.

Referring to FIG. 12, active structures including first to fourth channel layers 141, 142, 143, 144 and active regions 105 may be formed, and source/drain regions 130 may be formed.

The first to fourth channel layers 141, 142, 143, and 144 may include a semiconductor material including at least one of silicon (Si), silicon germanium (SiGe), and germanium (Ge), and may include different materials, and may or may not include impurities.

The active structures may be formed in a line shape extending in one direction, for example, the X-direction, and may be spaced apart from each other in the Y-direction. Depending on an aspect ratio, side surfaces of the active structures may have an inclined shape such that a width may increase toward the lower portion.

A device isolation layer 110 may be formed on the upper surface of the substrate 101 such that the active regions 105 may protrude. In this case, the upper surface of the device isolation layer 110 may be formed on a level lower than a level of the upper surface of the active regions 105.

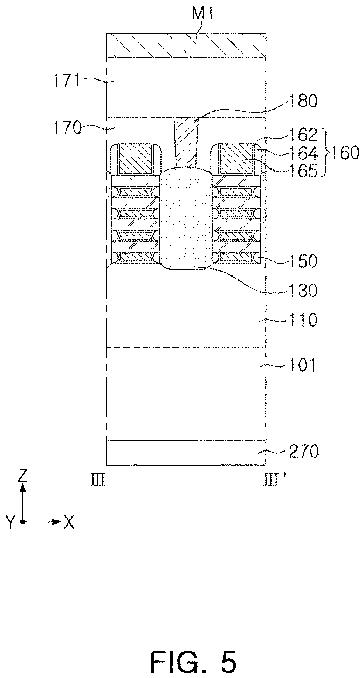

The source/drain regions 130 may be formed by growing from side surfaces of the active regions 105 and the channel structures 140, for example, by a selective epitaxial process. The source/drain regions 130 may include impurities by in-situ doping, and may include a plurality of layers having different doping elements and/or doping concentrations. In this process, a gate structure 160 (see FIG. 5) may also be formed in a region not illustrated.

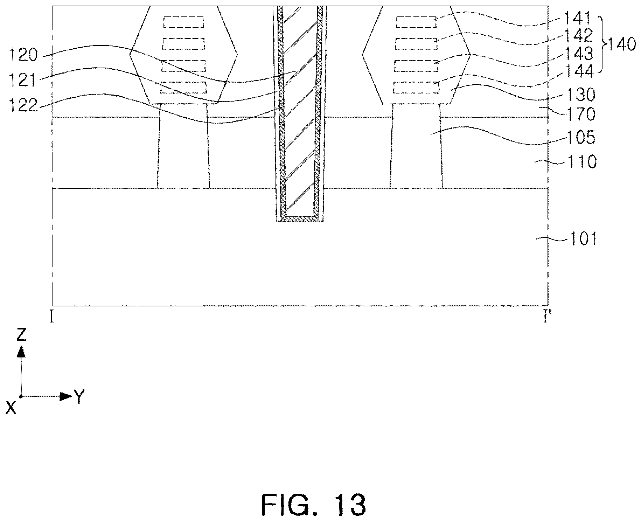

Referring to FIG. 13, a vertical insulating film 121 and a vertical power structure 120 may be formed. An interlayer insulating layer 170 covering the active regions 105 and the source/drain regions 130 may be formed on an upper surface of the device isolation layer 110.

A hole penetrating through the interlayer insulating layer 170 and extending into the substrate 101 may be formed between source/drain regions 130 adjacent to each other in the Y-direction, and an insulating layer and a conductive layer may be formed in order in the hole, thereby forming a vertical insulating film 121 and a vertical power structure 120. The vertical insulating film 121 may be formed to conformally cover a bottom surface and internal side surfaces of the hole, and the vertical power structure 120 may be formed to fill the hole. In this case, the vertical power structure 120 may be formed by being recessed into a portion of the substrate 101. Also, a first conductive barrier 122 covering a side surface and a lower surface of the vertical power structure 120 in (e.g. surrounded by) the vertical insulating film 121 may be further included.

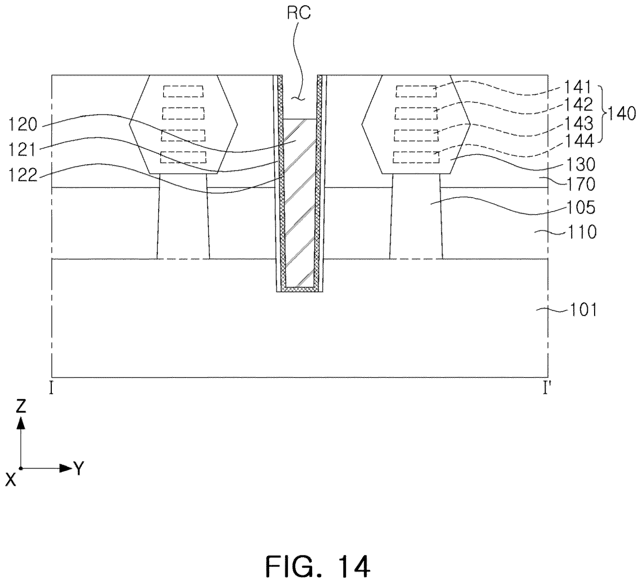

Referring to FIG. 14, a recess region RC may be formed by removing a portion of the upper end of the vertical power structure 120.

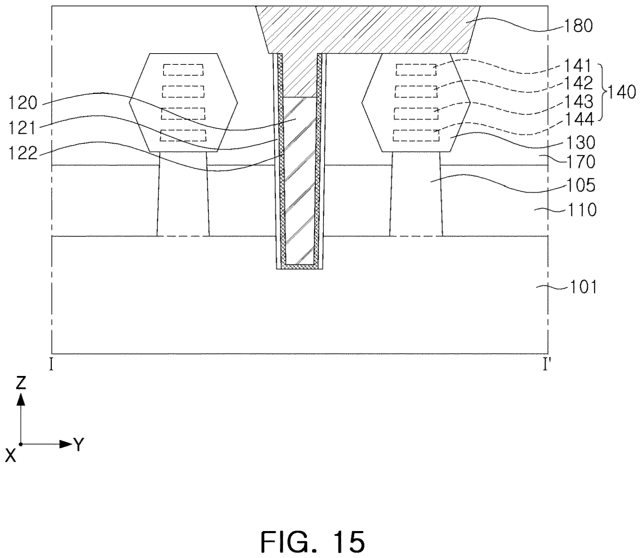

Referring to FIG. 15, a contact structure 180 may be formed by depositing a conductive material on in the recess region RC. The contact structure 180 may be formed by partially removing the interlayer insulating layer 170 and depositing a conductive material.

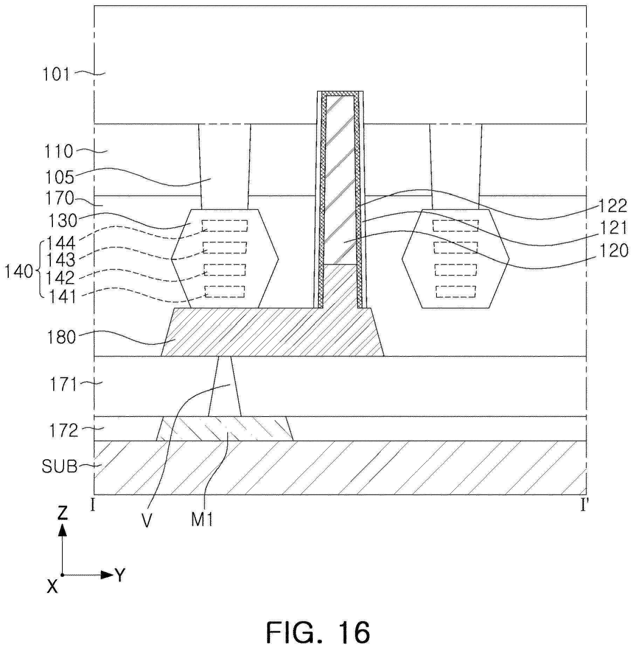

Referring to FIG. 16, an upper vias V and an upper interconnection line M1 may be formed, and a carrier substrate SUB may be attached. The upper vias V may be formed to be connected to the contact structures 180, and the upper interconnection line M1 may be formed to be connected to the upper vias V and the vertical power structure 120. Among the upper interconnection lines M1, an upper interconnection line M1 connected to the vertical power structure 120 may be configured as a power transfer line. In example embodiments, in the interconnection structure including the upper vias V and the upper interconnection lines M1, the number of layers formed by the vias and the interconnection lines may be varied.

The entire structure described with reference to FIGS. 12 to 15 may be attached to the carrier substrate SUB. In the description below, including the description with reference to FIG. 16, the entire structure illustrated in FIG. 15 may be rotated (e.g. flipped 180 degrees around a horizontal (e.g. X or Y) axis).

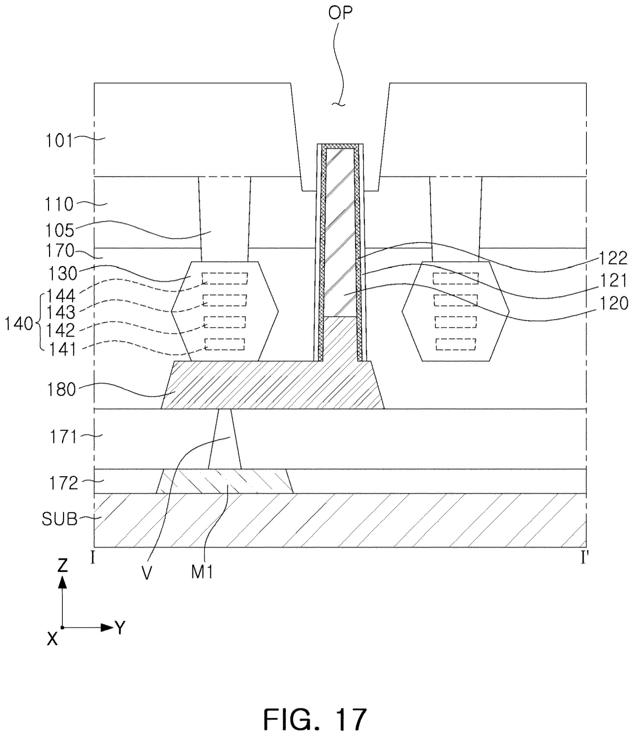

Referring to FIG. 17, by turning the substrate 101 over and removing the substrate 101 to a desired and/or alternatively predetermined thickness, an opening OP exposing the vertical power structure 120 may be formed.

The thickness from which the substrate 101 is removed may be varied in example embodiments. The substrate 101 may be removed and thinned by, for example, lapping, grinding or polishing processes.

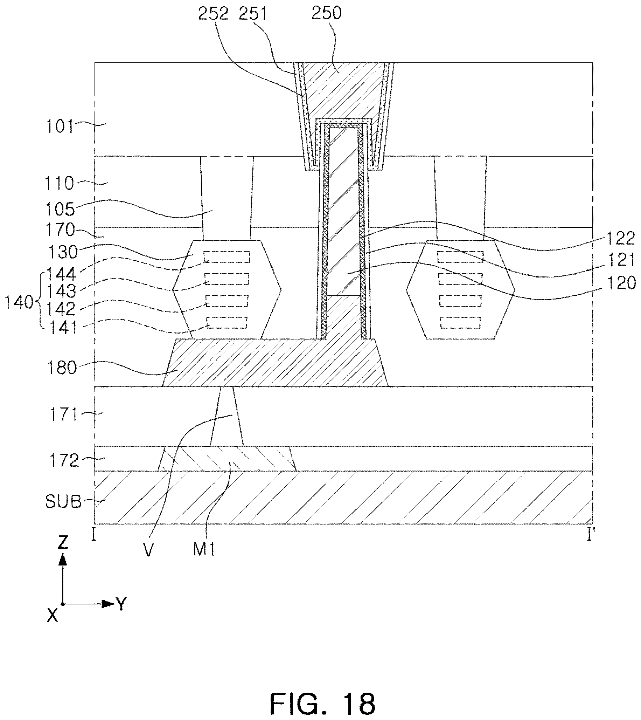

Referring to FIG. 18, a rear power structure 250, a rear insulating film 251, and a second conductive barrier 252 may be formed in the OP. The rear power structure 250 may be formed to cover a portion of a side surface of the vertical power structure 120 on the etched substrate 101. A rear insulating film 251 may be disposed on a side surface of the rear power structure 250, and a second conductive barrier 252 covering a side surface of the rear power structure 250 in the rear insulating film 251 may be disposed. The rear insulating layer 270 may be formed through a deposition process or may be formed of an oxide film or native oxide of the substrate 101.

Thereafter, referring to FIG. 2 together, a lower interconnection line M2 may be formed on the rear power structure 250, and the lower interconnection line M2 may be configured to have a size larger than a width of the rear power structure 250. The rear power structure 250 may be formed and the carrier substrate SUB may be removed.

The semiconductor device 100 may be packaged in a state in which the rear power structure 250 is disposed thereon, but example examples embodiment are not limited thereto.

According to example embodiments, by disposing the rear power structure to surround the vertical power structure, resistance may be limited and/or addressed, such that a semiconductor device having improved electrical properties may be provided.

While some example embodiments have been illustrated and described above, it will be apparent to those skilled in the art that modifications and variations may be made without departing from the scope of inventive concepts as defined by the claims.

Further embodiments are set out in the following clauses:
1. A semiconductor device, comprising:
   a substrate including an active region extending in a first direction;
   a gate structure on the active region, the gate structure extending in a second direction, the second direction intersecting the first direction, and the gate structure intersecting the active region;
   a source/drain region on the active region, the source/drain region on at least one side of the gate structure;
   a contact structure on the source/drain region and connected to the source/drain region;
   a device isolation layer surrounding the active region on the substrate;
   an interlayer insulating layer on the device isolation layer, the interlayer insulating layer covering the gate structure and the source/drain region;
   a vertical power structure penetrating through the substrate, the vertical power structure extending in a third direction, the third direction being perpendicular to an upper surface of the substrate, and the vertical power structure being connected to the contact structure;
   a first conductive barrier on a side surface of the vertical power structure;
   a rear power structure electrically connected to the vertical power structure, the rear power structure penetrating through a portion of the substrate and a portion of the device isolation layer; and
   a rear insulating film covering a side surface of the rear power structure, wherein
   the rear power structure overlaps the vertical power structure in the second direction and the third direction,
   a level of an upper end of the rear power structure is higher than a level of a lower end of the vertical power structure, and
   a width of an upper end of the rear power structure is greater than a width of the lower end of the vertical power structure.
2. The semiconductor device of clause 1, further comprising:
   a vertical insulating film on the first conductive barrier, wherein
   a portion of a side surface of the vertical insulating film is surrounded by the rear power structure.
3. The semiconductor device of clause 1 or clause 2, wherein the first conductive barrier covers a lower surface of the vertical power structure.
4. The semiconductor device of any preceding clause, further comprising:
   a second conductive barrier surrounding a side surface of the rear power structure, wherein
   the second conductive barrier is surrounded by the rear insulating film.
5. The semiconductor device of clause 4, wherein the rear power structure is electrically connected to the vertical power structure through the first conductive barrier and the second conductive barrier.
6. A semiconductor device, comprising:
   a substrate including an active region extending in a first direction;
   a gate structure on the active region, the gate structure extending in a second direction, the second direction intersecting the first direction;
   a source/drain region on the active region, the source/drain region on at least one side of the gate structure;
   a contact structure on the source/drain region and connected to the source/drain region;
   a device isolation layer surrounding the active region on the substrate;
   an interlayer insulating layer on the device isolation layer, the interlayer insulating layer covering the gate structure and the source/drain region;
   a vertical power structure penetrating through the device isolation layer and the interlayer insulating layer, the vertical power structure being connected to the contact structure and being below the contact structure;
   a rear power structure surrounding an entirety of a lower surface of the vertical power structure and a portion of a side surface of the vertical power structure, the rear power structure being electrically connected to the vertical power structure;
   a first conductive barrier on a side surface of the vertical power structure and the lower surface of the vertical power structure;
   a vertical insulating film surrounding a side surface of the first conductive barrier;
   a second conductive barrier on a side surface of the rear power structure and an upper surface of the rear power structure; and
   a rear insulating film on a side surface of the second conductive barrier, wherein
   the vertical power structure extends into a recessed portion of the substrate,
   an upper end of the vertical power structure includes a recess, and
   a portion of the contact structure extends into the recess of the upper end of the vertical power structure.

## Claims

1. A semiconductor device, comprising:
a substrate including an active region extending in a first direction;
a gate structure on the active region, the gate structure extending in a second direction, the second direction intersecting the first direction, and the gate structure intersecting the active region;
a source/drain region on the active region, the source/drain region on at least one side of the gate structure;
a contact structure on the source/drain region and connected to the source/drain region;
a device isolation layer surrounding the active region on the substrate;
an interlayer insulating layer on the device isolation layer, the interlayer insulating layer covering the gate structure and the source/drain region;
a vertical power structure penetrating through the device isolation layer and the interlayer insulating layer, the vertical power structure being connected to the contact structure and being below the contact structure;
a rear power structure surrounding an entirety of a lower surface of the vertical power structure and a portion of a side surface of the vertical power structure, the rear power structure being electrically connected to the vertical power structure;
a vertical insulating film covering the side surface of the vertical power structure, the vertical insulating film being between the vertical power structure and the rear power structure; and
a rear insulating film covering a side surface of the rear power structure.

2. The semiconductor device of claim 1, wherein
an upper end of the vertical power structure includes a recess, and
a portion of the contact structure extends into the recess of the vertical power structure.

3. The semiconductor device of claim 2, wherein the portion of the contact structure is in the vertical insulating film.

4. The semiconductor device of claim 2 or claim 3, wherein
a level of a central portion of an upper surface of the vertical power structure is lower than a level of an edge of an upper surface of the vertical power structure.

5. The semiconductor device of any preceding claim, wherein a lower surface of the contact structure is in contact with an upper end of the vertical insulating film.

6. The semiconductor device of any preceding claim, wherein
a level of an upper end of the rear power structure is higher than a level of an interfacial surface between the device isolation layer and the substrate.

7. The semiconductor device of claim 6, wherein
a lower end of the vertical power structure is higher than a level of an interfacial surface between the substrate and the device isolation layer, and
the lower end of the vertical power structure is lower than a level of an upper end of the rear power structure.

8. The semiconductor device of any of claims 1-6, wherein a lower end of the vertical power structure is lower than a level of an interfacial surface between the substrate and the device isolation layer

9. The semiconductor device of any preceding claim, wherein a lower end of the vertical insulating film is lower than a level of an interfacial surface between the substrate and the device isolation layer.

10. The semiconductor device of any preceding claim, wherein the rear insulating film is in contact with a side surface of the vertical insulating film.

11. The semiconductor device of any preceding claim, wherein the vertical power structure includes at least one of tungsten, molybdenum, copper and cobalt.

12. The semiconductor device of any preceding claim, wherein the rear power structure includes a same material as a material of the vertical power structure.

13. The semiconductor device of any preceding claim, wherein a portion of the contact structure overlaps a portion of the source/drain region in the first direction.

14. The semiconductor device of any preceding claim, further comprising:
a plurality of channel layers on the active region and spaced apart from each other in a third direction, wherein
the third direction is perpendicular to the first direction and the second direction, and
the plurality of channel layers are surrounded by the gate structure.

15. The semiconductor device of any preceding claim, wherein a portion of a side surface of the vertical insulating film is surrounded by the rear power structure.
